(19) Europäisches Patentamt

European Patent Office

Office européen des brevets

(11) **EP 4 685 557 A2**

(12) **EUROPEAN PATENT APPLICATION**

(43) Date of publication:
**28.01.2026   Bulletin 2026/05**

(21) Application number: **25191375.2**

(22) Date of filing: **23.07.2025**

(51) International Patent Classification (IPC):
**G03F 1/22** *(2012.01)*

(52) Cooperative Patent Classification (CPC):
**G03F 1/22**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **25.07.2024   JP 2024119979**

(71) Applicant: **Shin-Etsu Chemical Co., Ltd.
Tokyo 100-0005 (JP)**

(72) Inventors:
• **SUGIYAMA, Tomoaki
  Niigata, 9428601 (JP)**
• **HARADA, Daijitsu
  Niigata, 9428601 (JP)**
• **MATSUI, Harunobu
  Niigata, 9428601 (JP)**
• **TAKEUCHI, Masaki
  Niigata, 9428601 (JP)**

(74) Representative: **Mewburn Ellis LLP
Aurora Building
Counterslip
Bristol BS1 6BX (GB)**

(54) **MASK BLANK SUBSTRATE AND METHOD FOR PRODUCING SAME**

(57)    A mask blank substrate in which when a rectangular region which is surrounded by four sides that are located at 5 mm from four sides of a rectangular main surface of 152 mm or more × 152 mm or more in an inward direction and are parallel to the four sides of the main surface and in which an intersection of diagonal lines of the main surface forms a center is defined, the flatness of the rectangular region is 100 nm or less, and when the surface shape of the rectangular region is separated into an X direction component (Sx) and a Y direction component (Sy), and of a difference PVx between the maximum height and the minimum height of Sx and a difference between the maximum height and the minimum height of Sy, the smaller is $PV_{min}$ and the larger is $PV_{max}$, $PV_{min}/PV_{max}$ is 1/3 or less.

**FIG.1**

**Description**

TECHNICAL FIELD

The invention relates to a mask blank substrate for use in photolithography, and a method for producing the mask blank substrate, and more particularly to a mask blank substrate suitable for mask blanks used for producing a photomask for photolithography using extreme ultra violet (EUV) light as exposure light, and a method for producing the mask blank substrate.

BACKGROUND

With the recent growing interest in AI and IoT, arithmetic processing of enormous amounts of data has become necessary. This has led to demand for enhanced speeds and reduced power consumptions of the processing. To meet the demand, the performance of IC chips should be improved. An effective measure that is commonly used is to improve the refinement of electrical circuits. For improving the refinement of the circuits, an increased numerical aperture (NA), exposure light having a shorter wavelength, and the like are typically applied, and in recent years, EUV lithography (EUVL) using extreme ultraviolet (EUV) light has been coming into practical use.

In EUVL, photomasks are among important elements, and improving the flatness of a glass substrate for base plates (mask blanks) for photomasks is extremely important for performing accurate exposure. As a process for producing an ordinary glass substrate, double-sided simultaneous polishing is common, but a flatness that is good enough for use in EUVL cannot be obtained simply by double-sided simultaneous polishing. For achieving a high flatness, the flatness should be corrected according to a surface shape by polishing each surface. For this process, localized processing techniques such as localized etching and localized polishing are utilized. In these techniques, relatively convex regions on a main surface of a glass substrate are removed to make the entire glass substrate flatter. By using the wavefront correction function of an exposure apparatus, the surface shape of a photomask can be optically corrected to obtain a photomask having high optical flatness.

Due to the recent movement toward improved refinement, a high NA has been required for EUVL, and in EUVL of high NA generation, an anamorphic lens is utilized as an optical system. In conventional optical systems, a circuit on a mask is symmetrically scaled down in left/right direction (X-axis direction) and front/back direction (Y-axis direction), whereas in optical systems where an anamorphic lens is utilized, the circuit is asymmetrically scaled down in X-axis and Y-axis directions.

To respond to the improved refinement, the required value of flatness of a mask blank substrate has been raised at an accelerated pace. The required flatness has reached a level that can no longer be achieved simply by advancement of polishing techniques, and it has become required to selectively produce a mask blank substrate having a shape appropriate to exposure, instead of merely using a flatness as an index.

WO 2016/098452 (Patent Document 1) discloses a mask blank substrate which can be preferably used for EUVL, a mask blank substrate having a good flatness, and a method for producing the mask blank substrate.

JP-A 2017-116812 (Patent Document 2) discloses a mask blank substrate that is applicable to EUV lithography using an anamorphic lens. For the mask blank substrate, local slope angles in X-axis and Y-axis directions that define different reduction scales of the mask blank substrate, and a ratio of the local slope angles are specified. The effect of deviation of the image formation position of a substrate to be processed cannot be sufficiently suppressed simply by the approach of merely reducing the local slope. JP-A 2017-116812 (Patent Document 2) indicates that it is possible to relatively easily suppress the effect of deviation of the image formation position of a substrate to be processed, which may be caused by the local slope in an anamorphic exposure method.

Citation List

Patent Document 1:    WO 2016/098452
Patent Document 2:    JP-A 2017-116812
Patent Document 3:    JP-A 2010-194705

SUMMARY OF THE INVENTION

In an optical system using an anamorphic lens, a circuit is asymmetrically scaled down, and a positional deviation IPE during exposure is given by the following expression.

$$\text{IPE} = \text{d} \times \tan\theta/\text{M}$$

Herein, d is a flatness of a photomask surface, $\theta$ is an incident angle of exposure light, and M is a reduction scale.

As shown in the expression, IPE is inversely proportional to the reduction scale, so that IPE, as well as the reduction scale, changes depending on a direction of the photomask.

That is, since IPE is larger in a direction where the reduction scale is smaller, flatness in the direction has a relatively large effect on the IPE. Therefore, it can be said that in an EUVL optical system of high NA generation, IPE can be predicted more accurately by dividing the surface shape of the photomask along the direction.

The mask blank substrate in WO 2016/098452 (Patent Document 1) is a mask blank substrate whose flatness is improved equally in all directions, where direction dependency of the reduction scale in an optical system using an anamorphic lens is not taken into consideration with respect to the flatness of the mask blank substrate. Therefore, in an optical system using an anamorphic lens, the flatness of a mask blank substrate causes a significant effect on IPE.

In the mask blank substrate in JP-A 2017-116812 (Patent Document 2), a local slope is specified, and an effect of a regional surface shape in a predetermined measurement area of the main surface is taken into consideration, but an effect of a surface shape that covers a wide exposure area of the main surface of the mask blank substrate is not taken into consideration.

The invention has been made in view of the above-described circumstances, and an object of the invention is to provide a mask blank substrate capable of providing a photomask which ensures that in exposure using a photomask, in particular, EUVL exposure, transfer accuracy that is extremely advantageous for next generation EUV exposure with a high NA lens can be exhibited in a wide exposure area of a main surface, particularly over the entire exposure area, and a method capable of producing the mask blank substrate with high productivity.

The inventors have conducted intensive studies for solving the above-described problems, and resultantly found that a surface shape of a mask blank substrate is separated into an X direction component and a Y direction component, specifically, the surface shape of the mask blank substrate is approximated by a polynomial expression, and the surface shape approximated by the polynomial expression is separated into an X direction component and a Y direction component; a mask blank substrate in which the X direction component and the Y direction component of the separated surface shape differ in flatness can provide a photomask which is used in EUVL of high NA generation, undergoes little effect on IPE, and exhibits good transfer performance in a wide exposure area of a main surface, particularly over the entire exposure area; and the mask blank substrate can be produced with reliability and high productivity by localized processing under predetermined conditions. In this way, the invention has been completed.

Accordingly, the invention provides the following mask blank substrate and method for producing a mask blank substrate.

1. A mask blank substrate which has two main surfaces as a first main surface and a second main surface and in which each of the main surfaces has a rectangular shape of 152 mm or more $\times$ 152 mm or more, wherein

when a rectangular region which is surrounded by four sides that are located at 5 mm from four sides of the main surface in an inward direction and are parallel to the four sides of the main surface and in which an intersection of diagonal lines of the main surface forms a center is defined,
a flatness of the rectangular region on at least one of the first main surface and the second main surface is 100 nm or less, and
when a surface shape (S) of the rectangular region is separated into an X direction component (Sx) extending along one of the four sides of the main surface and a Y direction component (Sy) extending along another side orthogonally crossing the one side, and
of a PV value (PVx) that is a difference between a maximum height and a minimum height of the X direction component and a PV value (PVy) that is a difference between a maximum height and a minimum height of the Y direction component, the smaller is $\text{PV}_{\text{min}}$ and the larger is $\text{PV}_{\text{max}}$,
a ratio given by $\text{PV}_{\text{min}}/\text{PV}_{\text{max}}$ (PV ratio) is 1/3 or less.

2. The mask blank substrate of 1, wherein the surface shape (S) of the rectangular region is approximated by the expression (1) as a polynomial expression, and the X direction component (Sx) and the Y direction component (Sy) are separated from the expression (1) as the expression (2) and the expression (3), respectively.

$$\sum_{k=1}^{n} a_k x^k + \sum_{k=1}^{n} b_k y^k \qquad (1)$$

$$\sum_{k=1}^{n} a_k x^k \qquad (2)$$

$$\sum_{k=1}^{n} b_k y^k \qquad (3)$$

wherein k and n each represent the number of terms in the polynomial expression, a and b each represent a coefficient, x represents an X coordinate, and y represents a Y coordinate.

3. The mask blank substrate of 1, wherein $PV_{min}$ is 10 nm or less, and $PV_{max}$ is more than 0 nm and 30 nm or less.

4. The mask blank substrate of 1, wherein $PV_{min}$ is 5 nm or less, and $PV_{max}$ is more than 0 nm and 15 nm or less.

5. A method for producing a mask blank substrate, comprising finish polishing at least one of a first main surface and a second main surface of a basic plate for the mask blank substrate, and the steps of:

（A-0）measuring a surface shape (S0) of the main surface;

（B-0）calculating a surface shape (S) of the main surface by adding a finish polishing-induced change (ΔS) in surface shape of the main surface to the surface shape (S0) of the main surface;

（C-0）separating the surface shape (S) into an X direction component (Sx) and a Y direction component (Sy); and

（D-0）calculating a PV value (PVx) that is a difference between a maximum height and a minimum height of the X direction component (Sx) and a PV value (PVy) that is a difference between a maximum height and a minimum height of the Y direction component (Sy), followed by calculation of a ratio given by $PV_{min}/PV_{max}$ (PV ratio), where $PV_{min}$ is the smaller and $PV_{max}$ is the larger of the PV values (PVx and PVy).

6. The method of 5, wherein the finish polishing is performed when the PV ratio in step (D-0) is within a predetermined range.

7. The method of 5, further comprising a localized processing performed before the finish polishing, wherein when the PV ratio in step (D-0) is not within the predetermined range, the method further comprising

（E）performing the localized processing so as to decrease the PV ratio.

8. The method of 7, further comprising the steps of:

（A-1）measuring a surface shape (S1) of the main surface after localized processing;

（B-1）calculating a surface shape (S) of the main surface by adding a finish polishing-induced change (ΔS) in surface shape of the main surface to the surface shape (S1) of the main surface;

（C-1）separating the surface shape (S) in step (B-1) into an X direction component (Sx) and a Y direction component (Sy); and

（D-1）calculating a PV value (PVx) that is a difference between a maximum height and a minimum height of the X direction component (Sx) in step (C-1) and a PV value (PVy) that is a difference between a maximum height and a minimum height of the Y direction component (Sy) in step (C-1), followed by calculation of a ratio given by $PV_{min}/PV_{max}$ (PV ratio), where $PV_{min}$ is the smaller and $PV_{max}$ is the larger of the PV values (PVx and PVy).

9. The method of 8, wherein the finish polishing is performed when the PV ratio in step (D-1) is within a predetermined range.

10. The method of 8, wherein when the PV ratio in step (D-1) is not within the predetermined range, step (E) and steps (A-1) to (D-1) are repeated until the PV ratio is within the predetermined range.

11. The method of 6 or 9, further comprising the steps of:

（A-2）measuring a surface shape (S2) of the main surface after finish polishing;

（C-2）separating the surface shape (S2) taken as the surface shape (S) into an X direction component (Sx) and a Y direction component (Sy); and

（D-2）calculating a PV value (PVx) that is a difference between a maximum height and a minimum height of the X direction component (Sx) in step (C-2) and a PV value (PVy) that is a difference between a maximum height and a minimum height of the Y direction component (Sy) in step (C-2), followed by calculation of a ratio given by $PV_{min}/PV_{max}$ (PV ratio), where $PV_{min}$ is the smaller and $PV_{max}$ is the larger of the PV values (PVx and PVy).

12. The method of 11, comprising producing a substrate in which the predetermined range of the PV ratio is 1/3 or less,

a main surface of the substrate has a rectangular shape of 152 mm or more × 152 mm or more,

the surface shape is a surface shape of a rectangular region which is surrounded by four sides that are located at 5 mm from four sides of the main surface in an inward direction and are parallel to the four sides of the main surface and in which an intersection of diagonal lines of the main surface forms a center, and

a flatness of the rectangular region is 100 nm or less.

ADVANTAGEOUS EFFECTS

The mask blank substrate of the invention can provide a photomask which hardly undergoes an effect on IPE in exposure through EUVL of high NA generation using a photomask, in particular, an effect on IPE of the flatness of a substrate along with direction dependency of a reduction scale in exposure using an optical system with an anamorphic lens, and exhibits good transfer performance in a wide exposure area of a main surface, particularly over the entire exposure area. The method for producing a mask blank substrate according to the invention is capable of producing the mask blank with reliability and high productivity.

BRIEF DESCRIPTION OF THE DRAWING

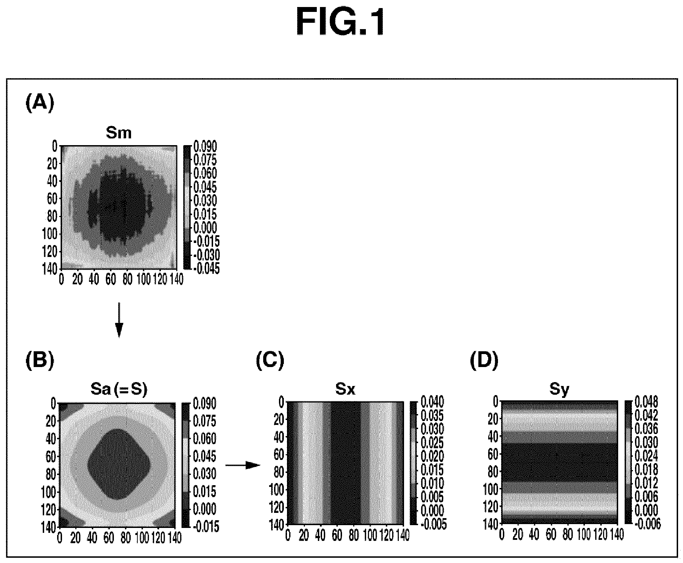

FIG. 1 is a conceptual diagram of separation of a surface shape.

FURTHER EXPLANATIONS; OPTIONS AND PREFERENCES

Hereinafter, the invention is described in detail.

A mask blank substrate of the invention has two main surfaces as a first main surface and a second main surface, and has a predetermined thickness. The main surface of the inventive mask blank substrate is preferably rectangular, and may be square or rectangular. The size and thickness of the main surface can be appropriately selected according to a required size of a photomask (exposure mask or transfer mask) produced using the mask blank substrate, and are not limited. The size of the main surface is preferably 152 mm or more × 152 mm or more, in other words, the length of any one of the four sides of the main surface is preferably 152 mm or more, and the length of a side orthogonally crossing the former side is preferably 152 mm or more. Here, the two sides that orthogonally cross each other may be identical or different in length. The upper limit of the size of the main surface is not limited, but is preferably 304 mm or less × 152 mm or less, more preferably 294 mm or less × 152 mm or less, still more preferably 284 mm or less × 152 mm or less. The thickness of the substrate is typically 6.35 mm.

The size of the main surface is, for example, 152 mm × 152 mm, 152 mm × 284 mm, 152 mm × 294 mm, or 152 mm × 304 mm. The thickness of the substrate is, for example, 6.35 mm. A substrate in which the size of a main surface is 152 mm × 152 mm and the thickness is 6.35 mm is a so-called 6025 substrate, and has two main surfaces as a first main surface and a second main surface each of which has a square shape of 6 inches × 6 inches. The substrate has a thickness of 0.25 inches.

The material for the inventive mask blank substrate of may be a conventional material, and is not limited. In fine patterning, $TiO_2$-doped quartz glass containing 3 to 10 wt% of $TiO_2$ and having very high dimensional stability at high temperature is preferably used because the substrate is exposed to high-energy exposure light. A basic plate for the mask blank substrate, which is synthesized, formed and processed by a conventional method, can be used.

A mask blank substrate is required to have a high flatness. This is because the higher the flatness, the more easily the intended exposure is performed. A substrate having a higher flatness is a mask blank substrate more suitable for fine patterning. The mask blank substrate has a first main surface on which an exposure pattern (such as a circuit pattern) is formed after film formation and a second main surface on which an exposure pattern is not formed, and the second main surface is adsorbed to and held by an exposure machine. Inter alia, in the leading-edge applications, where a reflective mask is mainly used, the first main surface is required to have an extremely high level of flatness. For improving the flatness of the first main surface, extensive studies are being made on flattening by localized processing techniques.

To meet demand for advanced refinement of patterns of photomasks, which has risen recent years, there has been a shift to an increased numerical aperture (NA) in EUV lithography using extreme ultraviolet (EUV) light (EUVL). Specifically, NA is increased from a conventional NA of 0.33 to a NA of 0.55, and in the EUV exposure with a high-NA lens, a non-conventional anamorphic optical system different is utilized. Therefore, in the case of a conventional NA of 0.33, the same reduction scale is applied to exposure in the X direction and the Y direction of the surface of the photomask, whereas in the case of a high NA of 0.55, there is a difference in reduction scale between the X direction and the Y direction of the surface of the photomask. Specifically, in the case of high NA generation with a NA of 0.55, the shape of a pattern exposed is not scaled down in a similar shape, but scaled down in a non-similar shape where the degree of scale-down in one direction is higher in relation to the ratio of the reduction scales in both directions. This enables advanced refinement of patterns, while increasing the effect of a difference in reduction scale to a non-negligible level. In a high NA of 0.55, the effect of the positional deviation (IPE) during exposure due to a difference in reduction scale is not negligible in the context of a surface shape of a photomask.

IPE is a parameter that has a direct effect on exposure quality. Since the EUV light is emitted at a predetermined incident angle $\theta$ (for example, 6°) with respect to a direction orthogonally crossing the main surface of the substrate of the photomask, the positional deviation of the exposure pattern on the wafer occurs depending on a surface shape (height map) of the photomask. IPE is given by the following expression.

$$IPE = d \times \tan\theta/M$$

Herein, IPE is a positional deviation, d is a flatness of a photomask surface, $\theta$ is an incident angle of exposure light, and M is a reduction scale.

The smaller the IPE, the less the positional deviation and the better the exposure.

In an EUV exposure machine set at a conventional NA of 0.33, the relationship between IPE and the reduction scale M is such that M is 4 regardless of the direction of the photomask. In an EUV exposure machine set at a NA of 0.55, a M=4 direction and a M=8 direction are provided. Therefore, the IPE varies depending on a direction of the photomask, and IPE in a direction where M is smaller is relatively significantly influenced. Thus, IPE in a photomask used for the EUV exposure machine set at a NA of 0.55 should be separated into X direction IPE (IPEx) and Y direction IPE (IPEy).

A relationship between IPE of the photomask surface (entire surface) (IPEs) and X direction IPE (IPEx) and Y direction IPE (IPEy) is given by the following expression.

$$IPEx = dx \times \tan\theta/Mx$$

$$IPEy = dy \times \tan\theta/My$$

$$IPEs = ((IPEx)^2 + (IPEy)^2)^{0.5}$$

Herein, dx is a flatness of the photomask surface in the X direction, dy is a flatness of the photomask surface in the Y direction, $\theta$ is an incident angle of exposure light, Mx is a reduction scale in the X direction, and My is a reduction scale in the Y direction.

As indicated by the expression, separation of IPE into X direction IPE (IPEx) and Y direction IPE (IPEy) requires separation of the flatness of the photomask surface into the flatness (dx) of the X direction component and the flatness (dy) of the Y direction component.

The surface shape as a mask blank substrate and the surface shape of the substrate as a mask blank in which a film is formed on a surface of the mask blank substrate are substantially equal from a practical standpoint, and there is substantially no different between the former and latter surface shapes. The surface shape of the substrate as a mask blank and the surface shape as a photomask are substantially equal from a practical standpoint, and there is substantially no different between the former and latter surface shapes. That is, IPE in the photomask heavily depends on the flatness of the mask blank substrate. Therefore, control of the flatness of the mask blank substrate is important, and enables improvement of IPE in the photomask.

In the invention, the surface shape of the mask blank substrate is separated into an X direction (X-axis direction) component and a Y direction (Y-axis direction) component (components in two directions orthogonally crossing each other), and the flatness of each of the X direction component and the Y direction component obtained by the separation of the surface shape. Thus, the invention provides a mask blank substrate in which there is a difference between the flatness of an X direction component and the flatness of a Y direction component (the flatness in one of the X direction and the Y direction is significantly higher). The mask blank substrate is capable of reducing positional deviation (IPE) during exposure and suitable for exposure using a lens with a high NA of 0.55 and an anamorphic optical system in which there is a difference in reduction scale between the X direction and the Y direction of the photomask. When the surface shape of the mask blank substrate is separated into an X direction component and a Y direction component, and the flatness of each of the X direction component and the Y direction component is evaluated. On the basis of the results, one of the X direction component and the Y direction component of the main surface of the mask blank substrate is more heavily polished by a technique such as localized processing. This enables the obtainment of a main surface in which the flatness in one of the X direction and the Y direction is significantly higher.

Heretofore, the flatness of the surface shape of the mask blank substrate has not been evaluated by separating the surface shape into an X direction component and a Y direction component. The surface shape of the mask blank substrate has not been made to have a significantly higher flatness in one of the X direction or the Y direction, or polishing for obtaining such a surface shape has not been performed.

For separating the surface shape (S) into an X direction component (Sx) and a Y direction component (Sy), polynomial approximation using a least squares method can be applied. For example, a method can be applied in which the surface shape of the mask blank substrate based on measurement is approximated by the expression (1) as a polynomial expression, and the obtained approximate surface shape is taken as the surface shape (S), and the X direction component (Sx) and the Y direction component (Sy) are separated as the expressions (2) and (3), respectively. In this way, the flatness of the mask blank substrate can be separated into a flatness (dx) of the X direction component and a flatness (dy) of the Y direction component more accurately.

$$\sum_{k=1}^{n} a_k x^k + \sum_{k=1}^{n} b_k y^k \qquad (1)$$

$$\sum_{k=1}^{n} a_k x^k \qquad (2)$$

$$\sum_{k=1}^{n} b_k y^k \qquad (3)$$

Herein, k and n each represent the number of terms in the polynomial expression, a and b each represent a coefficient, x represents an X coordinate, and y represents a Y coordinate. The subscript n is 2 or more, preferably 5 or more.

FIG. 1 is a conceptual diagram of separation of the surface shape (S) in the invention. Here, first, the surface shape of the main surface is measured to obtain a surface shape (Sm) shown in (A), and the obtained surface shape (Sm) is then corrected as necessary, and then approximated by a polynomial expression to obtain an approximate surface shape (Sa) shown in (B), which is taken as a surface shape (S), and separated into an X direction component (Sx) shown in (C) and a Y direction component (Sy) shown in (D).

Specifically, the separation and calculation of the X direction component (Sx) and the Y direction component (Sy) by polynomial approximation can be performed using the following expression.

$$S = \sum_{k=1}^{n} a_k x^k + \sum_{k=1}^{n} b_k y^k$$

$$Sx = \sum_{k=1}^{n} a_k x^k$$

$$Sy = \sum_{k=1}^{n} b_k y^k$$

wherein k and n each represent the number of terms in the polynomial expression, a and b each represent a coefficient, x represents an X coordinate, and y represents a Y coordinate.

Sx and Sy can also be given by the following.

$$Sx = a_1 x^1 + a_2 x^2 + a_3 x^3 + \ldots$$

$$Sy = b_1 y^1 + b_2 y^2 + b_3 y^3 + \ldots$$

Herein, $a_1$, $a_2$, $a_3$ ... each represent a coefficient of each order, x represents an X coordinate, $b_1$, $b_2$, $b_3$ ... each represent a coefficient of each order, and y represents a Y coordinate.

When the main surface of the mask blank substrate has a rectangular shape of 152 mm or more × 152 mm or more, particularly 152 mm × 152 mm, or 152 mm × 284 mm, the surface shape of the main surface can be very closely approximated by using up to 10 terms (n=10). It is noted that although the accuracy of approximation is enhanced as the number of terms increases, the calculation time and the approximation accuracy are in a trade-off relationship, and for this reason, approximation using up to 10 terms is preferred.

$$\sum_{k=1}^{10} a_k x^k + \sum_{k=1}^{10} b_k y^k \qquad (1)$$

$$\sum_{k=1}^{10} a_k x^k \qquad (2)$$

$$\sum_{k=1}^{10} b_k y^k \qquad (3)$$

Herein, k represents the number of terms in the polynomial expression, a and b each represent a coefficient, x represents an X coordinate, and y represents a Y coordinate.

From the X direction component (Sx) and the Y direction component (Sy) which are calculated as described above, a PV value (PVx) that is a difference between a maximum height and a minimum height of the X direction component and a PV value (PVy) that is a difference between a maximum height and a minimum height of the Y direction component can be calculated.

In the inventive mask blank substrate, when a rectangular region which is surrounded by four sides that are located at 5 mm from four sides of the main surface in an inward direction and are parallel to the four sides of the main surface and in which an intersection of diagonal lines of the main surface forms a center is defined, a surface shape (S) of the rectangular region is separated into an X direction component (Sx) extending along one of the four sides of the main surface, specifically, an X direction component (Sx) composed only of an X direction component and a Y direction component (Sy) extending along another side orthogonally crossing the one side, specifically, a Y direction component (Sy) composed only of a Y direction component, in one or both of the rectangular regions of the first main surface and the second main surface, particularly, in the rectangular region of the first main surface, and of a PV value (PVx) that is a difference between a maximum height and a minimum height of the X direction component and a PV value (PVy) that is a difference between a maximum height and a minimum height of the Y direction component, the smaller is $PV_{min}$ and the larger is $PV_{max}$, a ratio given by $PV_{min}/PV_{max}$ (PV ratio) is preferably 1/3 (about 0.33) or less, more preferably 1/4 (0.25) or less.

For example, when the size of the main surface is 152 mm × 152 mm, it is possible to define a rectangular region of 142 mm × 142 mm which is surrounded by sides parallel to the four sides of the main surface and in which the intersection of the diagonal lines of the main surface forms a center. When the size of the main surface is 152 mm × 284 mm, it is possible to define a rectangular region of 142 mm × 274 mm which is surrounded by sides parallel to the four sides of the main surface and in which the intersection of the diagonal lines of the main surface forms a center. When the shape of the main surface is not a square, it is more effective and effective to evaluate the center portion of the main surface. Therefore, for example, when the size of the main surface is 152 mm × 284 mm, the rectangular region may be substituted by a rectangular region based on a main surface whose shape is a square, whose short sides are identical in length and whose size is 152 mm × 152 mm, that is, a rectangular region of 142 mm × 142 mm which is surrounded by sides parallel to the four sides of the main surface and in which the intersection of the diagonal lines of the main surface forms a center.

When the PV ratio is in the above-mentioned range, the flatness of the component in one direction is sufficiently low. Therefore, by determining directions as the X direction and the Y direction set in an exposure apparatus such that more favorable IPE occurs, according to a flatness of a component in one direction and a flatness of a component in the other direction, followed by placement of a photomask in the exposure apparatus, good transfer accuracy can be obtained even in EUV exposure using a lens with a high NA of 0.55, in particular, exposure using an optical system based on an anamorphic lens optical system.

In the inventive mask blank substrate, there is a difference in flatness between the X direction and the Y direction (two directions orthogonally crossing each other) (the flatness in one of the X direction and the Y direction is significantly higher) on the main surface in the shape of the main surface. A photomask made from a mask blank substrate whose main surface has such a surface shape can ensure good transfer accuracy even in EUV exposure using a lens with a NA of 0.55. The X direction may be any of the directions of four sides of the rectangular region, and the Y direction is a direction orthogonally crossing the X direction.

In one or both of the rectangular regions of the first main surface and the second main surface, particularly, in the rectangular region of the first main surface, in the inventive mask blank substrate, the flatness of the rectangular region (flatness of the entire surface) is 100 nm or less, more preferably 50 nm or less, still more preferably 30 nm or less. The flatness is a PV (Peak to Valley) value, which is given by a difference between a height at the highest position and a height at the lowest position on the surface. As a reference plane for the height, a least squares plane of the surface can be used.

A substrate having a flatness (flatness of the entire surface) of more than 100 nm may have a PV ratio of 1/3 or less, but in EUV exposure, flatness above a certain level is required on a wide exposure area of the main surface, particularly over the entire exposure area. When the flatness is 100 nm, any of the PV value (PVx) that is a difference between a maximum height and a minimum height of the X direction component, and the PV value (PVy) that is a difference between a maximum height and the minimum height of the Y direction component does not exceed 100 nm, and in the main surface, the flatness in one of the X direction and the Y direction is not extremely higher. A mask blank having a flatness of 100 nm or less is suitable for EUV exposure. On the other hand, there is a possibility that a substrate having a flatness of more than 100 nm cannot be applied to a photomask that is used for EUV exposure. In the inventive mask blank substrate, the flatness (flatness of the entire surface) of the rectangular region is more than 0 nm, and the lower limit for practical use is typically 5 nm or more.

$PV_{min}$ is preferably 10 nm or less, more preferably 8 nm or less, still more preferably 5 nm or less. $PV_{max}$ is preferably more than 0 nm and 30 nm or less, more preferably more than 0 nm and 24 nm or less, still more preferably more than 0 nm and 15 nm or less. $PV_{min}$ and $PV_{max}$ are preferably a $PV_{min}$ of 10 nm or less and a $PV_{max}$ of more than 0 nm and 30 nm or less, more preferably a $PV_{min}$ of 8 nm or less and a $PV_{max}$ of more than 0 nm and 24 nm or less, still more preferably a $PV_{min}$ of 5 nm or less and a $PV_{max}$ of more than 0 nm and 15 nm or less. When $PV_{min}$ and $PV_{max}$ are within these ranges, flatness in both the X direction and the Y direction is high, flatness required in EUV exposure is secured, and higher flatness is obtained in one of the X direction or the Y direction.

Next, a method for producing a mask blank substrate according to the invention will be described.

The inventive method for producing a mask blank substrate comprises finish polishing of at least one of a first main surface and a second main surface of a mask blank substrate (a basic plate of the mask blank substrate). Preferably, the inventive method for producing a mask blank substrate further comprises localized processing of at least one of a first main surface and a second main surface of a mask blank substrate (a basic plate for the mask blank substrate), which is performed before finish polishing.

In production of a mask blank substrate, a basic plate for the mask blank substrate is prepared from a glass ingot. The basic plate for a mask blank substrate can be prepared typically by cutting a glass ingot into a predetermined shape to arrange an outer shape, and subsequently polishing main surfaces and end surfaces. The polishing can be performed in several steps of, for example, rough polishing, precision polishing, ultra-precision polishing and the like. The polishing can be performed using an abrading cloth and an abrading agent. The abrading agent is not limited. For example, an aqueous dispersion of cerium oxide which has an average primary particle size of 10 to 100 nm, an aqueous dispersion of silica nanoparticles which has an average primary particle size of 10 to 100 nm (colloidal silica aqueous dispersion), or the like can be used.

The inventive method for producing a mask blank substrate comprises the steps of:

(A-0) measuring a surface shape (S0) of the main surface;

(B-0) calculating a surface shape (S) of the main surface by adding a finish polishing-induced change ($\Delta S$) in surface shape of the main surface to the surface shape (S0) of the main surface;

(C-0) separating the surface shape (S) into an X direction component (Sx) and a Y direction component (Sy); and

(D-0) calculating a PV value (PVx) that is a difference between a maximum height and a minimum height of the X direction component (Sx) and a PV value (PVy) that is a difference between a maximum height and a minimum height of the Y direction component (Sy), followed by calculation of a ratio given by $PV_{min}/PV_{max}$ (PV ratio), where $PV_{min}$ is the smaller and $PV_{max}$ is the larger of the PV values (PVx and PVy),

all of which are carried out before localized processing of a basic plate for the mask blank substrate.

The area which is required to have a predetermined surface shape varies depending on a size of the main surface (substrate size). As an area in which the surface shape (S0) of the basic plate for the mask blank substrate is measured in step (A-0), a rectangular region appropriately defined depending on the size of the main surface can be used as an area to be measured. For example, when the main surface has a rectangular shape of 152 mm × 152 mm, the area in which the surface shape (S0) is measured is preferably a rectangular region of 142 mm × 142 mm which is surrounded by sides parallel to the four sides of the main surface and in which the intersection of the diagonal lines of the main surface forms a center. In the invention, the surface shape can be measured with, for example, a laser interferometer, and the surface shape can be obtained as a height map of the surface of interest.

The shape of the main surface before finish polishing is typically a shape in which a finish polishing-induced change in shape of the main surface is undistinguished (in general, a middle-convex shape (a shape in which the center portion of the main surface is raised), a middle-concave shape (a shape in which the central portion of the main surface is recessed), or the like), and the results of evaluating the flatness of the shape of the main surface before finish polishing are far from the results of evaluating the flatness of the shape of the main surface of the completed mask blank substrate.

The finish polishing-induced change in shape of the main surface is reproducible, and the change in shape of the main surface after finish polishing under predetermined polishing conditions can be confirmed and applied to the shape of the main surface before finish polishing to predict a shape of the main surface after finish polishing performed under predetermined polishing conditions. Accordingly, before finish polishing, the shape of the main surface which is obtained after finish polishing can be evaluated to determine whether the shape of the main surface which is obtained by finish polishing is good or not. The change in shape of the main surface after finish polishing under the predetermined polishing conditions can be obtained by processing, in advance, a substrate similar in surface shape to a substrate to be processed, and performing evaluation.

In the (B-0) step, as the finish polishing-induced change ($\Delta S$) in surface shape of the main surface, for example, a change ($\Delta S$) in surface shape obtained by evaluation by the above-described method in advance can be applied. Here, from the surface shape (S0) measured in step (A-0) and the finish polishing-induced change ($\Delta S$) in surface shape of the main surface, the surface shape (S) can be given by the following expression.

$$S = S0 + \Delta S$$

The obtained surface shape (S) is applied to step (C-0). In this way, a surface shape that reflects the shape of the main surface which is obtained after finish polishing can be applied.

In step (C-0), polynomial approximation based on a least square method can be applied for separation into the X direction component (Sx) and the Y direction component (Sy). For calculation of the X direction component (Sx) and the Y direction component (Sy), specifically, approximation by a polynomial expression given by the following expression.

$$S \ = \ \sum_{k=1}^{n} a_k x^k \ + \ \sum_{k=1}^{n} b_k y^k$$

$$S\,x = \sum_{k=1}^{n} a_k x^k$$

$$S\,y = \sum_{k=1}^{n} b_k y^k$$

wherein k and n each represent the number of terms in the polynomial expression, a and b each represent a coefficient, x represents an X coordinate, and y represents a Y coordinate.

When the main surface of the mask blank substrate has a rectangular shape of 152 mm or more $\times$ 152 mm or more, particularly 152 mm $\times$ 152 mm, or 152 mm $\times$ 284 mm, very favorable approximation can be provided by using a term of up to 10th order (n=10) for the approximation.

$$S \ = \ \sum_{k=1}^{10} a_k x^k \ + \ \sum_{k=1}^{10} b_k y^k$$

$$S\,x = \sum_{k=1}^{10} a_k x^k$$

$$S\,y = \sum_{k=1}^{10} b_k y^k$$

Herein, k represents the number of terms in the polynomial expression, a and b each represent a coefficient, x represents an X coordinate, and y represents a Y coordinate.

In step (D-0), the PV values of the X direction component (Sx) and the Y direction component (Sy) which are obtained in step (C-0) are calculated, and the PV ratio is calculated from the obtained PV values. Specifically, the PV value is a difference between a maximum height and a minimum height of the component, and can be calculated by subtracting the minimum height from the maximum height. The PV value is PVx for the component Sx and PVy for the component Sy.

When the PV ratio in step (D-0) is within a predetermined range, finish polishing can be performed without performing localized processing. When both $PV_{min}$ and $PV_{max}$ in step (D-0) are within predetermined ranges, finish polishing can be performed without performing localized processing. On the other hand, when the PV ratio in step (D-0) is not within a predetermined range, localized processing is preferably performed. Even when one of $PV_{min}$ and $PV_{max}$, or either $PV_{min}$ or $PV_{max}$ in step (D-0) is not within a predetermined range, localized processing can be performed.

The inventive method for producing a mask blank substrate may further comprise the step of

(E) performing localized processing so that the PV ratio decreases.

Specifically, in step (E), localized processing is performed so that the shape of a component in a direction corresponding to the smaller ($PV_{min}$) of the PV values (PVx and PVy) becomes flatter (one of PVx and PVy which corresponds to the smaller ($PV_{min}$) of PVx and PVy). For example, localized processing can be performed so that the Y direction component (Sy) becomes flatter when PVx>PVy, the X direction component (Sx) becomes flatter when PVx<PVy, and one of the X direction component (Sx) and the Y direction component (Sy) becomes flatter when PVx=PVy. Accordingly, the PV ratio can be decreased. In the localized processing, only a component in a direction where the component is made flatter may be processed, or components in both directions may be processed. For making one of the X direction component (Sx) and the Y direction component (Sy) flatter, a component in a direction where the component is made flatter should be selectively processed, whereas in general localized processing, processing of a component in one direction is accompanied by processing of a component in the other direction, and therefore localized processing should be performed so that a component in a direction where the component is made flatter is more heavily processed.

In the invention, localized processing can be performed on the main surface of the mask blank substrate so that relatively convex portions are selectively removed. The localized processing can be performed by localized polishing, specifically, polishing with an abrading cloth and an abrading agent. The abrading agent is not limited. For example, an aqueous dispersion of cerium oxide which has an average primary particle size of 10 to 100 nm, an aqueous dispersion of silica nanoparticles which has an average primary particle size of 10 to 100 nm (colloidal silica aqueous dispersion), or the like can be used. For the localized processing, a method such as magneto rheological finishing (MRF) can also be applied.

From the surface shape (S1) after localized processing and the finish polishing-induced change ($\Delta$S) in surface shape of the main surface, the surface shape (S) can be given by the following expression.

$$S = S1 + \Delta S$$

The surface shape (S1) after localized processing corresponds to the surface shape (S1) in step (A-1) and step (B-1). Ideally, S≒Sy is satisfied when processing is performed so that the X direction component (Sx) becomes flatter, and S≒Sx is satisfied when processing is performed so that the Y direction component (Sy) becomes flatter.

The inventive method for producing a mask blank substrate may further comprise the steps of:

(A-1) measuring a surface shape (S1) of the main surface after localized processing;
(B-1) calculating a surface shape (S) of the main surface by adding a finish polishing-induced change (ΔS) in surface shape of the main surface to the surface shape (S1) of the main surface;
(C-1) separating the surface shape (S) in step (B-1) into an X direction component (Sx) and a Y direction component (Sy); and
(D-1) calculating a PV value (PVx) that is a difference between a maximum height and a minimum height of the X direction component (Sx) in step (C-1) and a PV value (PVy) that is a difference between a maximum height and a minimum height of the Y direction component (Sy) in step (C-1), followed by calculation of a ratio given by $PV_{min}/PV_{max}$ (PV ratio), where $PV_{min}$ is the smaller and $PV_{max}$ is the larger of the PV values (PVx and PVy).

Steps (A-1), (B-1), (C-1) and (D-1) can be carried out in the same manner as in steps (A-0), (B-0), (C-0) and (D-0), respectively, by substituting the surface shape (S1) of the main surface after localized processing for the surface shape (S0) of the basic plate in steps (A-0) and (B-0).

When the PV ratio in step (D-1) is within a predetermined range, finish polishing can be performed without further performing localized processing. When both $PV_{min}$ and $PV_{max}$ in step (D-1) are within predetermined ranges, finish polishing can be performed without further performing localized processing. On the other hand, when the PV ratio in step (D-1) is not within a predetermined range, it is preferred to further perform localized processing. Even when one of $PV_{min}$ and $PV_{max}$, or either $PV_{min}$ or $PV_{max}$ in step (D-0) is not within a predetermined range, localized processing can be further performed. The localized processing can be performed in the same manner as in step (E).

When the PV ratio in step (D-1) is not within a predetermined range, step (E) and steps (A-1) to (D-1) are preferably repeated until the PV ratio is within the predetermined range. When one of $PV_{min}$ and $PV_{max}$, or either $PV_{min}$ or $PV_{max}$ in step (D-1) is not within a predetermined range, step (E) and steps (A-1) to (D-1) can be repeated until the PV ratio is within the predetermined range.

There is a possibility that the defect level of a main surface which is achieved simply by localized processing is not good enough particularly for mask blank substrates for state-of-the-art products. In production of a mask blank substrate according to the invention, the defect level is reduced by performing finish polishing. In the present invention, finish polishing can be performed by using a polishing cloth together with a polishing slurry containing, as a principal component, colloidal silica particles having an average primary particle size of 10 to 100 nm (a colloidal silica aqueous dispersion). As a polishing method, double-sided simultaneous polishing can be preferably performed using a double-sided polishing apparatus. Examples of the usable polishing cloth include, but are not limited to, soft cloths of suede type.

Preferably, the inventive method for producing a mask blank substrate further comprises the steps of:

(A-2) measuring a surface shape (S2) of the main surface after finish polishing;
(C-2) separating the surface shape (S2) taken as the surface shape (S) into an X direction component (Sx) and a Y direction component (Sy); and
(D-2) calculating a PV value (PVx) that is a difference between a maximum height and a minimum height of the X direction component (Sx) in step (C-2) and a PV value (PVy) that is a difference between a maximum height and a minimum height of the Y direction component (Sy) in step (C-2), followed by calculation of a ratio given by $PV_{min}/PV_{max}$ (PV ratio), where $PV_{min}$ is the smaller and $PV_{max}$ is the larger of the PV values (PVx and PVy).

Steps (A-2), (C-2) and (D-2) can be carried out in the same manner as in steps (A-0), (C-0) and (D-0), respectively, by substituting the surface shape (S2) of the main surface after finish polishing for the surface shape (S0) step (A-0). Here, since the surface shape (S2) is a surface shape after finish polishing, it is not necessary to allow for a finish polishing-induced change (ΔS) in surface shape of the main surface. Thus, it is not required that steps corresponding to steps (B-0) and (B-1) be provided between steps (A-2) and (C-2).

In the inventive method for producing a mask blank substrate, a predetermined range is set in evaluation of a value obtained in step (D-0), (D-1) or (D-2). The predetermined range of the PV ratio is preferably 1/3 (about 0.33) or less, more preferably 1/4 (0.25) or less. The predetermined range of $PV_{min}$ is preferably 10 nm or less, more preferably 8 nm or less, still more preferably 5 nm or less. The predetermined range of $PV_{max}$ is preferably more than 0 nm and 30 nm or less, more preferably more than 0 nm and 24 nm or less, still more preferably more than 0 nm and 15 nm or less.

The predetermined ranges of the PV ratio, $PV_{min}$ and $PV_{max}$ are preferred as the PV ratio, $PV_{min}$ and $PV_{max}$ for a

rectangular region appropriately defined according to a size of the main surface. For example, when the main surface has a rectangular shape of 152 mm × 152 mm, the predetermined ranges are preferred as the PV ratio, $PV_{min}$ and $PV_{max}$ for a rectangular region of 142 mm × 142 mm which is surrounded by sides parallel to the four sides of the main surface and in which the intersection of the diagonal lines of the main surface forms a center. In the inventive method for a mask blank substrate, the flatness of the rectangular region (flatness of the entire surface) is preferably 100 nm or less, more preferably 50 nm or less, still more preferably 30 nm or less. The flatness (flatness of the entire surface) is more than 0 nm, and the lower limit for practical use is typically 5 nm or more.

A photomask obtained by preparing a mask blank in which a film is formed on the inventive mask blank substrate, and patterning the film exhibits high flatness during EUV exposure using a lens with a NA of 0.55, in particular, exposure using an anamorphic lens optical system, and can be preferably applied to EUVL of next generation.

EXAMPLES

Examples and Comparative Examples are given below to more concretely illustrate the invention, although the invention is not limited by these Examples.

In examples and a comparative example, a localized processing apparatus described in JP-A 2010-194705 (Patent Document 3) was used for localized processing. In the localized processing using the apparatus, the entire surface of a substrate is polished while the moving speed of the small polishing tool is controlled. A target shape can be obtained by slowly moving the polishing tool in relatively convex portions and rapidly moving the polishing tool in relatively concave portions. As a processing tool of the localized processing apparatus, a wool felt buff was used. A polishing slurry obtained by mixing a small amount of a defoaming agent (Shin-Etsu Silicone KS-537, manufactured by Shin-Etsu Chemical Co., Ltd.) with silica nanoparticles (AJ-3540, manufactured by Nissan Chemical Corporation) was used. After the polishing, colloidal silica was removed by washing with a cleaning solution containing KOH, followed by drying.

In Examples and the Comparative Example, the substrate after the localized processing was placed on a carrier of a polishing apparatus including a soft suede polishing cloth, followed by finish polishing with a colloidal silica polishing solution. After the polishing, colloidal silica was removed by washing with a cleaning solution containing KOH, followed by drying.

Example 1

Ten glass substrates (152 mm × 152 mm square in size of each of first main surface and second main surface and 6.35 mm in thickness) formed of $SiO_2$ and $TiO_2$ ($TiO_2$ concentration: about 7 wt%) were prepared. The end surfaces (four surfaces other than main surfaces) of the glass substrate were chamfered and ground, and the first main surface and the second main surface were roughly polished and precisely polished with a polishing solution containing cerium oxide abrasive grains. Thereafter, ten glass substrates (substrates 1-1 to 1-10) were placed on a carrier of a double-sided polishing apparatus including a soft suede polishing cloth, and the first main surface and the second main surface were ultra-precisely polished using a colloidal silica abrasive grain polishing solution. After the ultra-precise polishing, the silica nanoparticles were removed by washing with a cleaning solution containing KOH, and dried to obtain a basic plate for a mask blank substrate.

Next, the surface shape (S0) of the first main surface of the basic plate for the mask blank substrate was measured with a surface shape measuring apparatus (UltraFlat, manufactured by Corning Tropel Corp) (step (A-0)). The surface shape measurement area of the main surface was a rectangular region of 142 mm × 142 mm which is surrounded by sides parallel to the four sides of the main surface and in which the intersection of the diagonal lines of the main surface forms a center. (The same applies to the measurement of the surface shape hereinafter.)

Next, change in surface shape due to finish polishing (ΔS), which had been measured in advance, was added to the surface shape (S0) to calculate the surface shape (S) (step (B-0)). ΔS was calculated by performing finish polishing on a substrate having a surface shape similar to the substrate to be processed.

Next, the surface shape (S) was approximated by the following polynomial expression having up to 10 terms, followed by separation into an X direction component (Sx) and a Y direction component (Sy) (step (C-0)).

$$S = \sum_{k=1}^{10} a_k x^k + \sum_{k=1}^{10} b_k y^k$$

$$Sx = \sum_{k=1}^{10} a_k x^k$$

$$Sy = \sum_{k=1}^{10} b_k y^k$$

Herein, k represents the number of terms in the polynomial expression, a and b each represent a coefficient, x represents an X coordinate, and y represents a Y coordinate.

Next, for each of the X direction component (Sx) and the Y direction component (Sy), the minimum height was subtracted from the maximum height to calculate a difference as a PV value (each of PVx and PVy). A ratio (PV ratio) given by $PV_{min}/PV_{max}$, where $PV_{min}$ is the smaller of the PV values (PVx and PVy) and $PV_{max}$ is the larger of the PV values, was calculated (step (D-0)). Table 1 shows the PV values (PVx and PVy) and the PV ratios.

Table 1

| Substrate | PVx [nm] | | PVy [nm] | | PV ratio | Direction in which PV value decreases |
|---|---|---|---|---|---|---|
| 1-1 | 49.3 | $PV_{max}$ | 41.3 | $PV_{min}$ | 0.84 | Y direction |
| 1-2 | 40.8 | $PV_{max}$ | 34.8 | $PV_{min}$ | 0.85 | Y direction |
| 1-3 | 37.9 | $PV_{max}$ | 31.9 | $PV_{min}$ | 0.84 | Y direction |
| 1-4 | 33.6 | $PV_{max}$ | 31.0 | $PV_{min}$ | 0.92 | Y direction |
| 1-5 | 45.0 | $PV_{max}$ | 44.1 | $PV_{min}$ | 0.98 | Y direction |
| 1-6 | 33.0 | $PV_{min}$ | 45.9 | $PV_{max}$ | 0.72 | X direction |
| 1-7 | 37.8 | $PV_{max}$ | 29.2 | $PV_{min}$ | 0.77 | Y direction |
| 1-8 | 34.2 | $PV_{max}$ | 28.1 | $PV_{min}$ | 0.82 | Y direction |
| 1-9 | 34.4 | $PV_{max}$ | 26.3 | $PV_{min}$ | 0.76 | Y direction |
| 1-10 | 36.0 | $PV_{min}$ | 41.5 | $PV_{max}$ | 0.87 | X direction |

In this example, the predetermined range of the PV ratio was 1/3 or less, but in any of the substrates, the PV ratio was not within the predetermined range. Therefore, a component in a component direction where the PV value is small was determined, and localized processing was performed such that the PV value of a component in a direction shown in Table 1 decreased, and the component in a component direction where the PV value is small was more heavily polished (step (E)).

The surface shape (S1) of the first main surface of the substrate after localized processing was measured with a surface shape measuring apparatus (UltraFlat, manufactured by Corning Tropel Corp) (step (A-1)). From the surface shape (S1), the flatness (flatness of the entire surface) of a rectangular region of 142 mm × 142 mm which is surrounded by sides parallel to the four sides of the main surface and in which the intersection of the diagonal lines of the main surface forms a center was calculated. Table 2 shows the results.

Next, change in surface shape due to finish polishing (ΔS), which had been measured in advance, was added to the surface shape (S1) to calculate the surface shape (S) (step (B-1)). ΔS was calculated by performing finish polishing on a substrate having a surface shape similar to the substrate to be processed.

Next, the surface shape (S) was approximated by a polynomial expression identical to that in step (C-0), followed by separation into an X direction component (Sx) and a Y direction component (Sy) (step (C-1)).

Next, for each of the X direction component (Sx) and the Y direction component (Sy), the minimum height was subtracted from the maximum height to calculate a difference as a PV value (each of PVx and PVy). A ratio (PV ratio) given by $PV_{min}/PV_{max}$, where $PV_{min}$ is the smaller of the PV values (PVx and PVy) and $PV_{max}$ is the larger of the PV values, was calculated (step (D-1)). Table 2 shows the PV values (PVx and PVy) and the PV ratios after localized processing.

Table 2

| Substrate | PVx [nm] | | PVy [nm] | | PV ratio | Flatness [nm] |
|---|---|---|---|---|---|---|
| 1-1 | 49.1 | $PV_{max}$ | 14.9 | $PV_{min}$ | 0.30 | 62 |
| 1-2 | 41.0 | $PV_{max}$ | 12.7 | $PV_{min}$ | 0.31 | 55 |
| 1-3 | 37.9 | $PV_{max}$ | 10.5 | $PV_{min}$ | 0.28 | 53 |
| 1-4 | 33.6 | $PV_{max}$ | 11.0 | $PV_{min}$ | 0.33 | 54 |
| 1-5 | 45.0 | $PV_{max}$ | 14.4 | $PV_{min}$ | 0.32 | 45 |
| 1-6 | 15.3 | $PV_{min}$ | 45.9 | $PV_{max}$ | 0.33 | 63 |
| 1-7 | 37.8 | $PV_{max}$ | 9.4 | $PV_{min}$ | 0.25 | 49 |
| 1-8 | 34.0 | $PV_{max}$ | 11.0 | $PV_{min}$ | 0.32 | 72 |

(continued)

| Substrate | PVx [nm] | | PVy [nm] | | PV ratio | Flatness [nm] |
|---|---|---|---|---|---|---|
| 1-9 | 34.4 | $PV_{max}$ | 11.0 | $PV_{min}$ | 0.32 | 54 |
| 1-10 | 10.0 | $PV_{min}$ | 41.5 | $PV_{max}$ | 0.24 | 56 |

For all of the substrates, the PV ratio was found to be within the predetermined range, and therefore it was determined that the main surface would have a predetermined surface shape after the finish polishing. The finish polishing was accordingly performed.

The surface shape (S2) of the first main surface of the substrate after finish polishing was measured with a surface shape measuring apparatus (UltraFlat, manufactured by Corning Tropel Corp) (step (A-2)). From the surface shape (S2), the flatness (flatness of the entire surface) of a rectangular region of 142 mm × 142 mm which is surrounded by sides parallel to the four sides of the main surface and in which the intersection of the diagonal lines of the main surface forms a center was calculated. Table 3 shows the results.

Next, the surface shape (S2) was substituted for the surface shape (S), and approximated by a polynomial expression identical to that in step (C-0), followed by separation into an X direction component (Sx) and a Y direction component (Sy) (step (C-2)).

Next, for each of the X direction component (Sx) and the Y direction component (Sy), the minimum height was subtracted from the maximum height to calculate a difference as a PV value (each of PVx and PVy). A ratio (PV ratio) given by $PV_{min}/PV_{max}$, where $PV_{min}$ is the smaller of the PV values (PVx and PVy) and $PV_{max}$ is the larger of the PV values, was calculated (step (D-2)). Table 3 shows the PV values (PVx and PVy) and the PV ratios of the mask blank substrates after finish polishing.

Table 3

| Substrate | PVx [nm] | | PVy [nm] | | PV ratio | Flatness [nm] |
|---|---|---|---|---|---|---|
| 1-1 | 31.9 | $PV_{max}$ | 7.1 | $PV_{min}$ | 0.22 | 53 |
| 1-2 | 36.3 | $PV_{max}$ | 10.2 | $PV_{min}$ | 0.28 | 68 |
| 1-3 | 29.0 | $PV_{max}$ | 8.8 | $PV_{min}$ | 0.30 | 70 |
| 1-4 | 24.5 | $PV_{max}$ | 7.6 | $PV_{min}$ | 0.31 | 50 |
| 1-5 | 26.7 | $PV_{max}$ | 8.5 | $PV_{min}$ | 0.32 | 54 |
| 1-6 | 9.2 | $PV_{min}$ | 37.8 | $PV_{max}$ | 0.24 | 55 |
| 1-7 | 30.8 | $PV_{max}$ | 8.4 | $PV_{min}$ | 0.27 | 51 |
| 1-8 | 30.2 | $PV_{max}$ | 8.8 | $PV_{min}$ | 0.29 | 62 |
| 1-9 | 29.3 | $PV_{max}$ | 7.2 | $PV_{min}$ | 0.25 | 55 |
| 1-10 | 9.3 | $PV_{min}$ | 33.8 | $PV_{max}$ | 0.28 | 72 |

Example 2

Three glass substrates (152 mm × 152 mm square in size of each of first main surface and second main surface and 6.35 mm in thickness) formed of $SiO_2$ and $TiO_2$ ($TiO_2$ concentration: about 7 wt%) were prepared. The end surfaces (four surfaces other than main surfaces) of the glass substrate were chamfered and ground, and the first main surface and the second main surface were roughly polished and precisely polished with a polishing solution containing cerium oxide abrasive grains. Thereafter, three glass substrates (substrates 2-1 to 2-3) were placed on a carrier of a double-sided polishing apparatus including a soft suede polishing cloth, and the first main surface and the second main surface were ultra-precisely polished using a colloidal silica abrasive grain polishing solution. After the ultra-precise polishing, the silica nanoparticles were removed by washing with a cleaning solution containing KOH, and dried to obtain a basic plate for a mask blank substrate.

Next, the surface shape (S0) of the first main surface of the basic plate for the mask blank substrate was measured with a surface shape measuring apparatus (UltraFlat, manufactured by Corning Tropel Corp) (step (A-0)).

Next, change in surface shape due to finish polishing (ΔS), which had been measured in advance, was added to the surface shape (S0) to calculate the surface shape (S) (step (B-0)). ΔS was calculated by performing finish polishing on a substrate having a surface shape similar to the substrate to be processed.

Next, the surface shape (S) was approximated by the following polynomial expression having up to 10 terms, followed by separation into an X direction component (Sx) and a Y direction component (Sy) (step (C-0)).

$$S = \sum_{k=1}^{10} a_k x^k + \sum_{k=1}^{10} b_k y^k$$

$$Sx = \sum_{k=1}^{10} a_k x^k$$

$$Sy = \sum_{k=1}^{10} b_k y^k$$

Herein, k represents the number of terms in the polynomial expression, a and b each represent a coefficient, x represents an X coordinate, and y represents a Y coordinate.

Next, for each of the X direction component (Sx) and the Y direction component (Sy), the minimum height was subtracted from the maximum height to calculate a difference as a PV value (each of PVx and PVy). A ratio (PV ratio) given by $PV_{min}/PV_{max}$, where $PV_{min}$ is the smaller of the PV values (PVx and PVy) and $PV_{max}$ is the larger of the PV values, was calculated (step (D-0)). Table 4 shows the PV values (PVx and PVy) and the PV ratios.

Table 4

| Substrate | PVx [nm] | | PVy [nm] | | PV ratio | Direction in which PV value decreases |
|---|---|---|---|---|---|---|
| 2-1 | 46.1 | $PV_{max}$ | 39.3 | $PV_{min}$ | 0.85 | X direction, Y direction |
| 2-2 | 51.8 | $PV_{max}$ | 46.7 | $PV_{min}$ | 0.90 | X direction, Y direction |
| 2-3 | 36.3 | $PV_{max}$ | 33.4 | $PV_{min}$ | 0.92 | X direction, Y direction |

In this example, the predetermined ranges of the PV ratio, $PV_{min}$ and $PV_{max}$ were 1/3 or less, 10 nm or less and more than 0 nm and 30 nm or less, respectively, but in any of the substrates, none of the PV ratio, $PV_{min}$ and $PV_{max}$ was within the predetermined range. Therefore, a component in a component direction where the PV value is small was determined, and localized processing was performed such that the PV value of a component in a direction shown in Table 4 decreased, and the component in a component direction where the PV value is small was more heavily polished (step (E)).

The surface shape (S1) of the first main surface of the substrate after localized processing was measured with a surface shape measuring apparatus (UltraFlat, manufactured by Corning Tropel Corp) (step (A-1)). From the surface shape (S1), the flatness (flatness of the entire surface) of a rectangular region of 142 mm × 142 mm which is surrounded by sides parallel to the four sides of the main surface and in which the intersection of the diagonal lines of the main surface forms a center was calculated. Table 5 shows the results.

Next, change in surface shape due to finish polishing (ΔS), which had been measured in advance, was added to the surface shape (S1) to calculate the surface shape (S) (step (B-1)). ΔS was calculated by performing finish polishing on a substrate having a surface shape similar to the substrate to be processed.

Next, the surface shape (S) was approximated by a polynomial expression identical to that in step (C-0), followed by separation into an X direction component (Sx) and a Y direction component (Sy) (step (C-1)).

Next, for each of the X direction component (Sx) and the Y direction component (Sy), the minimum height was subtracted from the maximum height to calculate a difference as a PV value (each of PVx and PVy). A ratio (PV ratio) given by $PV_{min}/PV_{max}$, where $PV_{min}$ is the smaller of the PV values (PVx and PVy) and $PV_{max}$ is the larger of the PV values, was calculated (step (D-1)). Here, in the first localized processing, any of the PV ratio, $PV_{min}$ and $PV_{max}$ failed to be within the predetermined range, and step (E) and steps (A-1) to (D-1) were repeated a number of times shown in Table 5 until all of the PV ratio, $PV_{min}$ and $PV_{max}$ were within the predetermined ranges. Table 5 shows the PV values (PVx and PVy) and the PV ratios after localized processing.

Table 5

| Substrate | PVx [nm] | | PVy [nm] | | PV ratio | Flatness [nm] | Number of localized processing operations |
|---|---|---|---|---|---|---|---|
| 2-1 | 12.4 | $PV_{max}$ | 4.1 | $PV_{min}$ | 0.33 | 25 | 3 |
| 2-2 | 11.0 | $PV_{max}$ | 2.9 | $PV_{min}$ | 0.26 | 26 | 3 |
| 2-3 | 13.9 | $PV_{max}$ | 4.1 | $PV_{min}$ | 0.29 | 22 | 4 |

Thereafter, for all of the substrates, the PV ratio, PV$_{min}$ and PV$_{max}$ were all found to be within the predetermined range, and therefore it was determined that the main plane would have a predetermined surface shape after the finish polishing. The finish polishing was accordingly performed.

The surface shape (S2) of the first main surface of the substrate after finish polishing was measured with a surface shape measuring apparatus (UltraFlat, manufactured by Corning Tropel Corp) (step (A-2)). From the surface shape (S2), the flatness (flatness of the entire surface) of a rectangular region of 142 mm × 142 mm which is surrounded by sides parallel to the four sides of the main surface and in which the intersection of the diagonal lines of the main surface forms a center was calculated. Table 6 shows the results.

Next, the surface shape (S2) was substituted for the surface shape (S), and approximated by a polynomial expression identical to that in step (C-0), followed by separation into an X direction component (Sx) and a Y direction component (Sy) (step (C-2)).

Next, for each of the X direction component (Sx) and the Y direction component (Sy), the minimum height was subtracted from the maximum height to calculate a difference as a PV value (each of PVx and PVy). A ratio (PV ratio) given by PV$_{min}$/PV$_{max}$, where PV$_{min}$ is the smaller of the PV values (PVx and PVy) and PV$_{max}$ is the larger of the PV values, was calculated (step (D-2)). Table 6 shows the PV values (PVx and PVy) and the PV ratios of the mask blank substrates after finish polishing.

Table 6

| Substrate | PVx [nm] | | PVy [nm] | | PV ratio | Flatness [nm] |
|---|---|---|---|---|---|---|
| 2-1 | 10.7 | PV$_{max}$ | 3.2 | PV$_{min}$ | 0.30 | 29 |
| 2-2 | 10.3 | PV$_{max}$ | 2.9 | PV$_{min}$ | 0.28 | 25 |
| 2-3 | 12.7 | PV$_{max}$ | 2.7 | PV$_{min}$ | 0.21 | 27 |

Comparative Example 1

Three glass substrates (152 mm × 152 mm square in size of each of first main surface and second main surface and 6.35 mm in thickness) formed of SiO$_2$ and TiO$_2$ (TiO$_2$ concentration: about 7 wt%) were prepared. The end surfaces (four surfaces other than main surfaces) of the glass substrate were chamfered and ground, and the first main surface and the second main surface were roughly polished and precisely polished with a polishing solution containing cerium oxide abrasive grains. Thereafter, three glass substrates (substrates 3-1 to 3-3) were placed on a carrier of a double-sided polishing apparatus including a soft suede polishing cloth, and the first main surface and the second main surface were ultra-precisely polished using a colloidal silica abrasive grain polishing solution. After the ultra-precise polishing, the silica nanoparticles were removed by washing with a cleaning solution containing KOH, and dried to obtain a basic plate for a mask blank substrate.

Next, the surface shape (S0) of the first main surface of the basic plate for the mask blank substrate was measured with a surface shape measuring apparatus (UltraFlat, manufactured by Corning Tropel Corp).

Next, change in surface shape due to finish polishing (ΔS), which had been measured in advance, was added to the surface shape (S0) to calculate the surface shape (S). ΔS was calculated by performing finish polishing on a substrate having a surface shape similar to the substrate to be processed.

In this example, localized processing was performed to the extent that the flatness of the surface shape (S) (flatness of the entire surface) was 100 nm or less, followed by finish polishing.

The surface shape (S2) of the first main surface of the substrate after finish polishing was measured with a surface shape measuring apparatus (UltraFlat, manufactured by Corning Tropel Corp). From the surface shape (S2), the flatness (flatness of the entire surface) of a rectangular region of 142 mm × 142 mm which is surrounded by sides parallel to the four sides of the main surface and in which the intersection of the diagonal lines of the main surface forms a center was calculated. Table 7 shows the results.

Next, the surface shape (S2) was approximated by the following polynomial expression having up to 10 terms, followed by separation into an X direction component (Sx) and a Y direction component (Sy).

$$\text{S} = \sum_{k=1}^{10} a_k x^k + \sum_{k=1}^{10} b_k y^k$$

$$\text{S x} = \sum_{k=1}^{10} a_k x^k$$

$$\mathrm{S}\ \mathrm{y} = \sum_{k=1}^{10} b_k y^k$$

Herein, k represents the number of terms in the polynomial expression, a and b each represent a coefficient, x represents an X coordinate, and y represents a Y coordinate.

Next, for each of the X direction component (Sx) and the Y direction component (Sy), the minimum height was subtracted from the maximum height to calculate a difference as a PV value (each of PVx and PVy). A ratio (PV ratio) given by $PV_{min}/PV_{max}$, where $PV_{min}$ is the smaller of the PV values (PVx and PVy) and $PV_{max}$ is the larger of the PV values, was calculated. Table 7 shows the PV values (PVx and PVy) and the PV ratios of the mask blank substrates after finish polishing.

Table 7

| Substrate | PVx [nm] | | PVy [nm] | | PV ratio | Flatness [nm] |
|---|---|---|---|---|---|---|
| 3-1 | 13.7 | $PV_{max}$ | 10.7 | $PV_{min}$ | 0.78 | 33 |
| 3-2 | 28.6 | $PV_{min}$ | 33.1 | $PV_{max}$ | 0.86 | 88 |
| 3-3 | 40.3 | $PV_{max}$ | 19.9 | $PV_{min}$ | 0.49 | 95 |

**Claims**

1.  A mask blank substrate which has two main surfaces as a first main surface and a second main surface and in which each of the main surfaces has a rectangular shape of 152 mm or more × 152 mm or more, wherein

    when a rectangular region which is surrounded by four sides that are located at 5 mm from four sides of the main surface in an inward direction and are parallel to the four sides of the main surface and in which an intersection of diagonal lines of the main surface forms a center is defined,
    a flatness of the rectangular region on at least one of the first main surface and the second main surface is 100 nm or less, and
    when a surface shape (S) of the rectangular region is separated into an X direction component (Sx) extending along one of the four sides of the main surface and a Y direction component (Sy) extending along another side orthogonally crossing the one side, and
    of a PV value (PVx) that is a difference between a maximum height and a minimum height of the X direction component and a PV value (PVy) that is a difference between a maximum height and a minimum height of the Y direction component, the smaller is $PV_{min}$ and the larger is $PV_{max}$,
    a ratio given by $PV_{min}/PV_{max}$ (PV ratio) is 1/3 or less.

2.  The mask blank substrate of claim 1, wherein the surface shape (S) of the rectangular region is approximated by the expression (1) as a polynomial expression, and the X direction component (Sx) and the Y direction component (Sy) are separated from the expression (1) as the expression (2) and the expression (3), respectively:

$$\sum_{k=1}^{n} a_k x^k + \sum_{k=1}^{n} b_k y^k \qquad (1)$$

$$\sum_{k=1}^{n} a_k x^k \qquad (2)$$

$$\sum_{k=1}^{n} b_k y^k \qquad (3)$$

    wherein k and n each represent the number of terms in the polynomial expression, a and b each represent a coefficient, x represents an X coordinate, and y represents a Y coordinate.

3.  The mask blank substrate of claim 1, wherein $PV_{min}$ is 10 nm or less, and $PV_{max}$ is more than 0 nm and 30 nm or less.

4.  The mask blank substrate of claim 1, wherein $PV_{min}$ is 5 nm or less, and $PV_{max}$ is more than 0 nm and 15 nm or less.

5. A method for producing a mask blank substrate, comprising finish polishing at least one of a first main surface and a second main surface of a basic plate for the mask blank substrate, and the steps of:

(A-0) measuring a surface shape (S0) of the main surface;
(B-0) calculating a surface shape (S) of the main surface by adding a finish polishing-induced change ($\Delta$S) in surface shape of the main surface to the surface shape (S0) of the main surface;
(C-0) separating the surface shape (S) into an X direction component (Sx) and a Y direction component (Sy); and
(D-0) calculating a PV value (PVx) that is a difference between a maximum height and a minimum height of the X direction component (Sx) and a PV value (PVy) that is a difference between a maximum height and a minimum height of the Y direction component (Sy), followed by calculation of a ratio given by $PV_{min}/PV_{max}$ (PV ratio), where $PV_{min}$ is the smaller and $PV_{max}$ is the larger of the PV values (PVx and PVy).

6. The method of claim 5, wherein the finish polishing is performed when the PV ratio in step (D-0) is within a predetermined range.

7. The method of claim 5, further comprising a localized processing performed before the finish polishing, wherein when the PV ratio in step (D-0) is not within the predetermined range, the method further comprising
(E) performing the localized processing so as to decrease the PV ratio.

8. The method of claim 7, further comprising the steps of:

(A-1) measuring a surface shape (S1) of the main surface after localized processing;
(B-1) calculating a surface shape (S) of the main surface by adding a finish polishing-induced change ($\Delta$S) in surface shape of the main surface to the surface shape (S1) of the main surface;
(C-1) separating the surface shape (S) in step (B-1) into an X direction component (Sx) and a Y direction component (Sy); and
(D-1) calculating a PV value (PVx) that is a difference between a maximum height and a minimum height of the X direction component (Sx) in step (C-1) and a PV value (PVy) that is a difference between a maximum height and a minimum height of the Y direction component (Sy) in step (C-1), followed by calculation of a ratio given by $PV_{min}/PV_{max}$ (PV ratio), where $PV_{min}$ is the smaller and $PV_{max}$ is the larger of the PV values (PVx and PVy).

9. The method of claim 8, wherein the finish polishing is performed when the PV ratio in step (D-1) is within a predetermined range.

10. The method of claim 8, wherein when the PV ratio in step (D-1) is not within the predetermined range, step (E) and steps (A-1) to (D-1) are repeated until the PV ratio is within the predetermined range.

11. The method of claim 6 or 9, further comprising the steps of:

(A-2) measuring a surface shape (S2) of the main surface after finish polishing;
(C-2) separating the surface shape (S2) taken as the surface shape (S) into an X direction component (Sx) and a Y direction component (Sy); and
(D-2) calculating a PV value (PVx) that is a difference between a maximum height and a minimum height of the X direction component (Sx) in step (C-2) and a PV value (PVy) that is a difference between a maximum height and a minimum height of the Y direction component (Sy) in step (C-2), followed by calculation of a ratio given by $PV_{min}/PV_{max}$ (PV ratio), where $PV_{min}$ is the smaller and $PV_{max}$ is the larger of the PV values (PVx and PVy).

12. The method of claim 11, comprising producing a substrate in which the predetermined range of the PV ratio is 1/3 or less,

a main surface of the substrate has a rectangular shape of 152 mm or more $\times$ 152 mm or more,
the surface shape is a surface shape of a rectangular region which is surrounded by four sides that are located at 5 mm from four sides of the main surface in an inward direction and are parallel to the four sides of the main surface and in which an intersection of diagonal lines of the main surface forms a center, and
a flatness of the rectangular region is 100 nm or less.

# FIG.1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016098452 A
- JP 2017116812 A
- JP 2010194705 A